(19) Europäisches Patentamt
European Patent Office
Office européen des brevets

(11) **EP 4 253 986 A1**

(12) **EUROPEAN PATENT APPLICATION**

(43) Date of publication:
**04.10.2023 Bulletin 2023/40**

(21) Application number: **22165204.3**

(22) Date of filing: **29.03.2022**

(51) International Patent Classification (IPC):
**G01R 33/565** [(2006.01)]

(52) Cooperative Patent Classification (CPC):
**G01R 33/56509; G01R 33/56563**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
• **Eidgenössische Technische Hochschule (ETH)**
**8092 Zürich (CH)**
• **Universität Zürich**
**8006 Zürich (CH)**

(72) Inventor: **The designation of the inventor has not yet been filed**

(74) Representative: **Schmauder & Partner AG**
**Patent- & Markenanwälte VSP**
**Zwängiweg 7**
**8038 Zürich (CH)**

(54) **METHOD OF ESTIMATING MOTION OF AN OBJECT AND/OR MAGNETIC FIELD OFFSETS DURING AN MRI SCAN**

(57) In a method of estimating motion of an object and/or magnetic field offsets in a region surrounding the object during a magnetic resonance (MR) imaging scan of the object, superimposed magnetic fields and radiofrequency fields are generated according to an MR sequence for forming images, the MR sequence comprising a train of sequence modules, each sequence module comprising a radiofrequency (RF) excitation segment and an image encoding gradient segment, the MR sequence further comprising a plurality of navigator gradient segments. The navigator signal is acquired along a trajectory in k-space and expressed as a discrete time series comprising a predefined number of complex-valued signal datapoints. The navigator signal acquired in a first sequence module is used to calculate a transformation matrix which relates rotation angles and translational shifts and/or changes of the magnetic field to corresponding changes in navigator signal in a first order approximation. The navigator signal acquired in a subsequent sequence module is used to estimate object motion in terms of a translational displacement and a rotational displacement of the object and/or magnetic field offsets in terms of a scalar field variation and a vectorial field variation between the first sequence module and the subsequent sequence module by solving a corresponding linear least-squares estimation problem.

Fig. 1

**Description**

**Field of the Invention**

The present invention generally relates to a method of estimating motion of an object and/or magnetic field offsets during a magnetic resonance (MR) imaging scan of the object.

**Background of the Invention**

Patient motion is one of the leading causes of image artifacts in MR imaging. Many different methods for motion correction have been developed during the last few decades [1-3]. K-space navigators are a particularly promising approach, because they are a purely MR-signal-based approach that does not require any additional hardware.
Methods of navigator-based motion estimation have been described, among others, in US 6,771,068 B2 and US 7,358,732,B2.

**Summary of the Invention**

It is the principal object of the present invention to overcome the limitations and disadvantages of currently known methods.
According to one aspect of the invention, there is provided a method of estimating motion of an object during a magnetic resonance (MR) imaging scan of the object, wherein a main magnetic field is generated in the object of interest by a main magnet and wherein superimposed magnetic fields and radiofrequency fields are generated according to an MR sequence for forming images,

- the MR sequence comprising a train of sequence modules,
- each sequence module comprising a radiofrequency (RF) excitation segment and an image encoding gradient segment,
- said MR sequence further comprising a plurality of navigator gradient segments, in which method
- object signal is acquired with an RF receive coil or coil array during a measurement segment of each sequence module,
- navigator signal is acquired with said RF receive coil during each one of said navigator gradient segments.

The term "object of interest" shall be understood to include any objects amenable to magnetic resonance imaging. In particular, this term shall also include any human or animal subject, including human patients in need of diagnostic and/or therapeutic intervention.
According to this aspect

- said navigator signal is acquired along a trajectory $k(t)$ in k-space
- said navigator signal in a given sequence module is expressed as a discrete time series comprising a predefined number N of complex-valued signal data points $s(k(t_i))$, wherein i = 1 to N,
- the navigator signal $s(k(t_i))$ acquired in a first sequence module is used to calculate a transformation matrix M which relates rotation angles and translational shifts to corresponding changes in navigator signal in a first- order approximation,
- the navigator signal $\tilde{s}(k(t_i))$ acquired in a subsequent sequence module is used to estimate object motion in terms of a translational displacement $\Delta\boldsymbol{x}$ and a rotational displacement $\theta$ of the object between said first sequence module and said subsequent sequence module by solving the following linear least-squares estimation problem:

$$\min_{\Delta x_1,\Delta x_2,\Delta x_3,\theta_1,\theta_2,\theta_3} \left\| (\tilde{s} - s) - M \begin{pmatrix} \Delta x_1 \\ \Delta x_2 \\ \Delta x_3 \\ \theta_1 \\ \theta_2 \\ \theta_3 \end{pmatrix} \right\|_2^2$$

For brevity, said navigator signal $\tilde{s}(k(t_i))$ acquired in a subsequent sequence module will also be denoted as "subsequent navigator signal $\tilde{s}(k(t_i))$". Moreover, for the sake of clarity and simpler notation, the method will first be explained without regard to multichannel RF receive arrays. It will be explained afterwards how to process navigator signals acquired using a multichannel array.

Advantageous embodiments are defined hereinbelow and in the dependent claims.

The invention relies on the principle that rotations of an imaged object rotate the k-space signal accordingly, while translations lead to a linear phase shift on the signal. These are well-known properties of the Fourier transform. Formally, if one denotes by $s(k(t))$ and $\tilde{s}(k(t))$ the k-space signal before and after applying a 3x3 rotation matrix $R(\theta)$ and a 3D shift by the vector $\Delta x$, then:

$$\tilde{s}\big(k(t)\big) = s\big(R(\theta)k(t)\big)e^{i\Delta x^{T}R(\theta)k(t)}$$

Here, $\theta = (\theta_1, \theta_2, \theta_3)^T$ denotes a column vector of three rotation angles, each one around one coordinate axis. Similarly, $\Delta x = (\Delta x_1, \Delta x_2, \Delta x_3)^T$ is a three-element column vector, which describes the translational displacements along the three coordinate axes. If the rotation angles and translation vector are small, then the above equation can be approximated by a first-order Taylor expansion, which can be written as a linear function of the angles and shift. To this end, one needs to interpret $\tilde{s}$ as a function of rotation angles $\theta$ and shifts $\Delta x$.

The assumption of small rotation angles and shifts is satisfied if the imaged object only performs small motions during the imaging scan. If the object performs larger motion, the assumption is usually still satisfied if the estimated motion parameters are fed back to the MR scanner system immediately, and the scanner compensates for object motion in real-time, as explained in US 6771068 B2. In particular, the orientation of the scanner gradient coordinate system must follow rotations of the imaged object. Furthermore, to compensate for translation of the object, a phase offset must be added onto the navigator and imaging signal.

Calculating the derivatives of the above equation with respect to the shifts $\Delta x_1, \Delta x_2, \Delta x_3$ is straightforward since the complex exponential function has the following well-known power series expansion:

$$e^{ix} = \sum_{n=0}^{\infty} \frac{(ix)^n}{n!} = 1 + ix + O(n^2)$$

Finding the derivatives (or an approximation thereof) of the expression with respect to the rotation angles $\theta_1$, $\theta_2$, $\theta_3$ is more challenging and will be explained hereinbelow. If one denotes these derivatives by $\frac{ds}{d\theta_d}\theta_d$ (for $d = 1,2,3$), then the Taylor expansion is as follows:

$$\tilde{s}\big(k(t)\big) - s\big(k(t)\big) = \sum_{d=1}^{3} \frac{ds}{d\theta_d}\theta_d + i\Delta x^T k(t)s\big(k(t)\big)$$

In theory, the derivatives $\frac{ds}{d\theta_d}$ can be calculated using the chain rule of differentiation:

$$\frac{ds}{d\theta_d} = \frac{\partial s}{\partial k} \cdot \frac{\partial}{\partial \theta_d}[R(\theta)k(t)]$$

In practice, however, the partial derivative $\frac{\partial s}{\partial k}$ is unknown. Instead, if one interprets the signal $s(k(t))$ as a function of time, the time-derivative s(t) can be calculated. It is equivalent to the directional derivative of $s(k(t))$ in the direction of $k(t)$, which is the tangential vector of the navigator k-space trajectory.

$$\dot{s}(t) = \frac{\partial s}{\partial k} \cdot \dot{k}(t)$$

From linear algebra it is known that, given two vectors v and w, the vector v can be written as the sum of two vectors such that the first vector is parallel to w and the second vector is orthogonal to w. The first of these two vectors is also called the orthogonal projection of v onto w. In this way, the rotational displacement $\frac{\partial}{\partial \theta_d}[R(\theta)\boldsymbol{k}(t)]$ can be split into a tangential component of the k-space trajectory (a multiple of $\dot{\boldsymbol{k}}(t)$), and a component which is orthogonal to $\boldsymbol{k}(t)$.

$$\frac{\partial}{\partial \theta_d}[R(\theta)\boldsymbol{k}(t)] = \frac{\dot{\boldsymbol{k}}(t)}{\left\|\dot{\boldsymbol{k}}(t)\right\|^2}\left(\dot{\boldsymbol{k}}(t)\right)^T \frac{\partial}{\partial \theta_d}[R(\theta)\boldsymbol{k}(t)] + \cdots (orthogonal\ component)$$

By combining the last three equations, one can see that the derivative $\frac{ds}{d\theta_d}$ can be split into a tangential and an orthogonal part.

$$\frac{ds}{d\theta_d} = \frac{\partial s}{\partial k} \cdot \frac{\partial}{\partial \theta_d}[R(\theta)\boldsymbol{k}(t)] = \frac{\dot{s}(t)}{\left\|\dot{\boldsymbol{k}}(t)\right\|^2}\left(\dot{\boldsymbol{k}}(t)\right)^T \frac{\partial}{\partial \theta_d}[R(\theta)\boldsymbol{k}(t)] + \cdots (orthogonal\ component)$$

Calculating the derivative in any direction orthogonal to k(t), would require k-space data from the neighborhood of the navigator trajectory, which is not sampled. One practical solution to this problem is to consider only the tangential component of the derivative $\frac{ds}{d\theta_d}$ , denoted here as $\eta_d$:

$$\eta_d(t) = \frac{\dot{s}(t)}{\left\|\dot{\boldsymbol{k}}(t)\right\|^2}\left(\dot{\boldsymbol{k}}(t)\right)^T \frac{\partial}{\partial \theta_d}[R(\theta)\boldsymbol{k}(t)]$$

Alternatively, the full derivatives $\frac{ds}{d\theta_d}$ can be determined by reference measurement of finite differences under small rotations. For a sufficiently small angle a, one can then determine the derivatives as

$$\frac{ds}{d\theta_d} \approx \frac{1}{\alpha}[s(R(\alpha \cdot e_d)\,\boldsymbol{k}(t)) - s(\boldsymbol{k}(t))]$$

Here, $e_d$ denotes the d-th standard unit vector. Navigator signals $s(R(\alpha \cdot e_d)\,\boldsymbol{k}(t))$ are acquired for a small rotation around each of the three coordinate axes. In other words, the transformation matrix M is calculated from a set of initial navigator signals, namely the navigator signal $s(\boldsymbol{k}(t_i))$ acquired in said first sequence module and the navigator signals $s_j(\boldsymbol{k}(t_i))$ acquired in one or further sequence modules, which are all executed before said subsequent navigator signal $\tilde{s}(\boldsymbol{k}(t_i))$ used to estimate object motion.

Since the measurement noise on the complex-valued navigator signals follows a zero-mean Gaussian distribution, one calculates the angles θ and shift vector Δx by linear least-squares estimation. The spectrometer samples the MR signal only at discrete timepoints $t_1, t_2, ..., t_n$. It is advantageous to write the estimation problem in matrix-vector form. One defines the following matrix M, which relates rotation angles and shifts to signal perturbations. Each row of M corresponds to one time point $t_i$ at which the spectrometer has acquired the signal value $s(\boldsymbol{k}(t_i))$. The first three columns of M represent the derivatives of the signal with respect to the shifts $\Delta x_1, \Delta x_2$, and $\Delta x_3$, respectively. The last three columns represent the derivatives (or approximations thereof) with respect to the rotation angles $\theta_1, \theta_2, \theta_3$.

$$M = \begin{pmatrix} ik_1(t_1)s(k(t_1)) & ik_2(t_1)s(k(t_1)) & ik_3(t_1)s(k(t_1)) & \eta_1(t_1) & \eta_2(t_1) & \eta_3(t_1) \\ ik_1(t_2)s(k(t_2)) & ik_2(t_2)s(k(t_2)) & ik_3(t_2)s(k(t_2)) & \eta_1(t_2) & \eta_2(t_2) & \eta_3(t_2) \\ \vdots & \vdots & \vdots & \vdots & \vdots & \vdots \\ ik_1(t_n)s(k(t_n)) & ik_2(t_n)s(k(t_n)) & ik_3(t_n)s(k(t_n)) & \eta_1(t_n) & \eta_2(t_n) & \eta_3(t_n) \end{pmatrix}$$

If one stacks the sampled MR signal into column vectors $\boldsymbol{s}, \tilde{\boldsymbol{s}}$, one needs to solve the following linear least-squares estimation problem:

$$\min_{\Delta x_1, \Delta x_2, \Delta x_3, \theta_1, \theta_2, \theta_3} \left\| (\tilde{\boldsymbol{s}} - \boldsymbol{s}) - M \begin{pmatrix} \Delta x_1 \\ \Delta x_2 \\ \Delta x_3 \\ \theta_1 \\ \theta_2 \\ \theta_3 \end{pmatrix} \right\|_2^2$$

According to an advantageous embodiment (claim2), this is done by multiplication of the signal vectors and the Moore-Penrose pseudoinverse of M:

$$\begin{pmatrix} \Delta x_1 \\ \Delta x_2 \\ \Delta x_3 \\ \theta_1 \\ \theta_2 \\ \theta_3 \end{pmatrix} = M^+ (\tilde{\boldsymbol{s}} - \boldsymbol{s})$$

Given the usual acquisition bandwidths in magnetic resonance imaging and the expected readout time of the navigator signals, the number of rows of the matrix M will be significantly larger than the number of columns. Thus, the estimation problem is highly overdetermined.

It will be obvious to a person skilled in the art that, apart from applying the Moore-Penrose pseudoinverse, there exist many different well-established methods to calculate the solution of the above least-squares estimation problem. These include, among others, the QR decomposition or the singular-value decomposition (SVD). Moreover, instead of calculating the exact solution, one could approximate it using methods like the conjugate gradients (CG) algorithm. One might also choose to apply some form of regularization to the matrix M to improve the conditioning of the estimation problem. The most common choice would be Tikhonov regularization, but many other variants are possible.

If the navigator signal is acquired using an RF coil array with several separate receive channels, one can calculate the matrix M separately for the navigator signal from each receive channel. If $s_c, \tilde{s}_c$ denote the signals that were acquired from channel c, and $M_c$ denotes the matrix calculated only from signals from channel c, one can calculate $\theta$ and $\Delta\boldsymbol{x}$ by introducing a sum over the receive channels into the linear least-squares problem:

$$\min_{\Delta x_1, \Delta x_2, \Delta x_3, \theta_1, \theta_2, \theta_3} \sum_{c=1}^{C} \left\| (\tilde{\boldsymbol{s}}_c - \boldsymbol{s}_c) - M_c \begin{pmatrix} \Delta x_1 \\ \Delta x_2 \\ \Delta x_3 \\ \theta_1 \\ \theta_2 \\ \theta_3 \end{pmatrix} \right\|_2^2$$

Alternatively, one can combine the signal values from the separate receive channels into one virtual receive channel by means of a weighted sum. This process is known in MRI literature as coil compression or array compression. The matrix M and, ultimately, the values of $\theta$ and $\Delta\boldsymbol{x}$ would then be calculated from the combined navigator signal.

In simple terms, the invention relies on a novel algorithm for navigator-based motion estimation that uses a linearized perturbation model of complex-valued signal changes for estimating rotations and translations with high accuracy and low computational complexity.

The timing of the navigator gradient segments may be selected in accordance with other requirements of the MRI scan. It will be understood that the temporal separation between subsequent navigator gradient segments shall be small enough to allow neglec-tion of higher order terms in the applied formalism.

According to an advantageous embodiment (claim 3), one navigator gradient segment is executed in each one of the sequence modules. In other embodiments, a navigator gradient segment is applied e.g. every second or every third sequence module. In principle one could also apply a series of non-equidistant navigator gradient segments.

As will also be understood, the navigator gradient segments shall be applied in appropriate regions of the MR sequence, i.e. in regions which do not overlap with the RF excitation segment or the image encoding segment. According to an advantageous embodiment (claim 4), each navigator gradient segment of a respective sequence module is executed between the RF excitation segment and the image encoding segment of said respective sequence module. According to another advantageous embodiment (claim 5), each navigator gradient segment of a respective sequence module is executed after the image encoding segment of said respective sequence module but before the RF excitation segment of a sequence module following said respective sequence module.

According to a further aspect of the invention (claim 6), there is provided a method of estimating magnetic field offsets in a region surrounding an object during a magnetic resonance (MR) imaging scan of the object.

Using the same principle of Taylor expansion and linear least-squares estimation, one can also estimate magnetic field offsets. The MR signal of an object, which is placed in the scanner bore, and whose transverse magnetization is described by a function p(x) of the 3-dimensional spatial coordinates x, is given by the formula

$$s\big(\boldsymbol{k}(t)\big) = \int \rho(x) e^{-i x^T \boldsymbol{k}(t)}\, d\boldsymbol{x}$$

In case of unwanted offsets $\Delta B(\boldsymbol{x}, t)$ in the magnetic field, the equation changes to

$$\tilde{s}\big(\boldsymbol{k}(t)\big) = \int \rho(\boldsymbol{x}) e^{-i x^T \boldsymbol{k}(t)} e^{-i\gamma \int_0^t \Delta B(\boldsymbol{x},\tau)\, d\tau}\, d\boldsymbol{x}$$

In order to estimate the field offset $\Delta B(\boldsymbol{x}, t)$, one must first parametrize it so that it can be expressed with a finite number of parameters. Therefore, one chooses a set of basis functions that are deemed suitable to express the field offsets. One natural choice for the parametrization with respect to the spatial coordinate x is a subset of the spherical harmonics (e.g. up to 2nd or 3rd order) among a large range of common magnetic field expansions. For the temporal coordinate $t$, one could choose e.g. a polynomial basis.

The zeroth-order spherical harmonic function describes a spatially uniform magnetic field offset. In particular, if the offsets are constant with respect to the location x and the acquisition time t (during one navigator acquisition), then one can write $\int_0^t \Delta B(\boldsymbol{x}, \tau)\, d\tau = {}_{\Delta B_0} \cdot t$. The effect of such a background field offset during encoding is equivalent to multiplying the unperturbed signal with a phase offset, which is linear in time.

$$\tilde{s}\big(\boldsymbol{k}(t)\big) = s\big(\boldsymbol{k}(t)\big) e^{-i\gamma \Delta B_0 \cdot t} \approx s\big(\boldsymbol{k}(t)\big)(1 - i\gamma \Delta B_0 \cdot t)$$

The first-order spherical harmonics describe linearly increasing magnetic fields in one of the three coordinate directions (so-called gradient fields). Gradient fields are linear in the location x and therefore take the form $\Delta B(\boldsymbol{x}, t) = G_1 x_1 + G_2 x_2 + G_3 x_3$ (assuming that they are constant in time), where the coefficients $G_d$ are scalars which denote the gradient strength in the three coordinate directions.

$$\tilde{s}\big(\boldsymbol{k}(t)\big) = \int \rho(\boldsymbol{x}) e^{-i\gamma \sum_{d=1}^{3} x_d (\boldsymbol{k}_d(t) + G_d \cdot t)}\, d\boldsymbol{x}$$

The effect of these background field gradients is equivalent to acquiring the signal at a modified k-space trajectory $\tilde{\boldsymbol{k}}(t)$.

$$\tilde{s}\big(\boldsymbol{k}(t)\big) = s\big(\tilde{\boldsymbol{k}}(t)\big) = s\big(\boldsymbol{k}(t) + \gamma (G_1 \quad G_2 \quad G_3)^T \cdot t\big)$$

As in the case of rotation estimation, displacement factors $\lambda_d(t)$ can be calculated.

$$\lambda_d(t) = \gamma t \frac{\dot{s}(t)}{\left\| \dot{\boldsymbol{k}}(t) \right\|^2} \dot{\boldsymbol{k}}_d(t)$$

As for rotation and translation estimation, one constructs a matrix Q, which relates the field offset parameters to the resulting signal changes.

$$Q = \begin{pmatrix} -i\gamma t_1\, s(k(t_1)) & \lambda_1(t_1) & \lambda_2(t_1) & \lambda_3(t_1) \\ -i\gamma t_2\, s(k(t_2)) & \lambda_1(t_2) & \lambda_2(t_2) & \lambda_3(t_2) \\ \vdots & \vdots & \vdots & \vdots \\ -i\gamma t_3\, s(k(t_n)) & \lambda_1(t_n) & \lambda_2(t_n) & \lambda_3(t_n) \end{pmatrix}$$

Using this matrix, one calculates the field parameters by linear least-squares estimation:

$$\min_{\Delta B_0, G_1, G_2, G_3} \left\| (\tilde{s} - s) - Q \begin{pmatrix} \Delta B_0 \\ G_1 \\ G_2 \\ G_3 \end{pmatrix} \right\|_2^2$$

Beyond spatially uniform ($\Delta B_0$) and spatially linear ($G_1$, $G_2$, $G_3$) field offsets, the same principle can equally be used in conjunction with any other set of basis functions deemed suitable to expand expected field offsets. One natural choice is a subset of the spherical harmonics (e.g. up to 2nd or 3rd order) among a large range of common magnetic field expansions. The field expansion may also be chosen specifically for a given object, subject, or body part, using pre-measurement (e.g. by field mapping) or simulation to determine suitable basis functions. In each of these cases, to deploy the proposed method, the key step is to determine the derivatives of the navigator signals with respect to the coefficients of the field expansion, with those derivatives forming the columns of the model matrix Q. Depending on the basis functions, these derivatives, or approximations thereof, may be available analytically or must be determined by measurement or simulation. For measurement of the signal derivative, one option is to acquire navigator signals first in the reference state and then, again, in the presence of a small field offset of the spatial structure given by the basis function in question. A good approximation of the derivative is then given by the difference of the navigator signals divided by the strength of the perturbation in the scale of the basis function. This option is straightforward, e.g., for a basis formed from the fields patterns that can be generated with available gradient and shim coils. Available gradient and shim fields form particularly favorable bases in that they not only readily permit measurement of the respective signal derivatives but also enable active compensation of field offsets, once detected, by actuation of the same gradient and shim channels.

Additionally, besides arbitrary spatial patterns, basis functions for field expansion may also be equipped with temporal change across the duration of the navigator acquisition. One natural option is temporal change according to powers of time ($1, t, t^2, t^3$ ...), permitting the determination of Taylor series with respect to time. Another useful option is exponential decay over time ($e^{-at}$) to capture field offset caused by eddy currents. With any combination of chosen spatial and temporal variation for each basis function, the corresponding column of the Q matrix is again given by the derivative of the navigator signal with respect to the related expansion coefficient, determined analytically, by measurement, or by simulation.

According to a further aspect of the invention (claim 7), there is provided a method of estimating (i) motion of an object, and (ii) magnetic field offsets in a region surrounding the object during a magnetic resonance (MR) imaging scan of the object. The method combines the above described aspects and relies on a transformation matrix R combining the above defined matrices M and Q, i.e. a matrix with the following rows:

$$R = \begin{pmatrix} M_{11} & M_{12} & M_{13} & M_{14} & M_{15} & M_{16} & Q_{11} & Q_{12} & Q_{13} & Q_{14} \\ M_{21} & M_{22} & M_{23} & M_{24} & M_{25} & M_{26} & Q_{21} & Q_{22} & Q_{23} & Q_{24} \\ \vdots & \vdots & \vdots & \vdots & \vdots & \vdots & \vdots & \vdots & \vdots & \vdots \\ M_{N1} & M_{N2} & M_{N3} & M_{N4} & M_{N5} & M_{N6} & Q_{N1} & Q_{N2} & Q_{N3} & Q_{N4} \end{pmatrix}$$

Further aspect of the invention are defined in claims 7, 8 and 9, and explained hereinbelow.

One can use the estimated rotation angles, translational shifts, and/or field offsets, to compensate for the effects of object motion and field offsets in real-time during the scan procedure. This is generally referred to as prospective correction.

In simple terms, object motion is compensated in real-time by re-aligning the imaging volume to the rotated and shifted object. Object rotation is compensated by rotating subsequent gradient waveforms accordingly. Translation is corrected by adding a linear phase offset to the subsequent MR signals.

Since constant field offsets add a phase onto the MR signal, which is linear in acquisition time, they can be compensated by removing this phase offset from the signal values. Higher-order field offsets can be compensated using the shim coils of the MR system.

Alternatively, the effects of object motion and/or field offsets can be compensated during image reconstruction, after the scan is completed. This is generally referred to as retrospective correction.

One can also combine prospective and retrospective correction. This is useful, for example, if the real-time correction exhibits a time delay between estimating the motion and field parameters, and applying the compensation. In this case, one can use retrospective correction to correct residual errors, which could not be compensated during prospective correction because of the time delay.

For all implementations of estimation as described above (of motion parameters, field offset parameters, or both), it is favorable to use resulting estimates for active compensation during the respective MRI scan. Active compensation of motion is typically done by corresponding rotation and translation of the coordinate system in which the MRI sequence, including the navigator, is played out. This concept is known as prospective motion correction (PMC). Active compensation of field offsets is done by corresponding gradient and shim actuation as well as actuation of a $0^{th}$-order shim (uniform field) or equivalent signal demodulation. Importantly, besides eliminating error from acquired image data, such compensation also emulates the reference situation, in which the reference navigator was acquired, so that incremental motion and field offset to be detected with each individual repetition of the navigator, is small and thus consistent with first-order perturbation approach underlying the methodology.

With or without run-time compensation, perturbation of acquired raw image data by residual effective motion and/or field offsets can be addressed at the image reconstruction stage. The latter is usually most numerically benign (best-conditioned) when the underlying effective motion and field offsets are small. Therefore, correcting for detected motion and field offsets at the reconstruction level is generally most effective in combination with preceding run-time compensation.

**Brief description of the drawings**

The above mentioned and other features and objects of this invention and the manner of achieving them will become more apparent and this invention itself will be better understood by reference to the following description of various embodiments of this invention taken in conjunction with the accompanying drawings, which show the following:

Fig. 1      a sequence diagram of a 3D T2$^*$-weighted FFE sequence with 3D orbital navigator gradients inserted after the excitation and before the image encoding gradients;

Fig. 2      an orbital navigator k-space trajectory; (a): parametric plot of the trajectory shape; (b): plots of the trajectory, gradients, and slew rate over time; the trajectory is made up of three orthogonal circles, with smooth transitions in between them; at a radius of 200 rad/m, the navigator gradients can be executed in about 1.65 milliseconds;

Fig. 3      (a): estimated rotation angles (upper panel) and translational shift (lower panel) from an experiment with a motionless phantom (pineapple); (b): standard deviation (lower panel) and root mean squares (upper panel) of the rotation angles and translation parameters over time;

Fig. 4      (a) estimated motion parameters, namely, rotation around AP axis (upper panel) and shift along the anterior-posterior (AP) axis (lower panel) from an in-vivo experiment where the volunteer was instructed to hold still. (b): spectra of the motion time series of two selected axes, namely, spectrum of rotations around the left-right (LR) axis (upper panel) showing a peak in the spectrum at 1.22 Hz, and spectrum of shifts along the head-foot (HF) axis (lower panel) showing a peak at 0.30 Hz;

Fig. 5      estimated motion parameters in terms of rotation angle (upper panel) and shift (lower panel) from an in-vivo experiment where the volunteer was instructed to move the head around randomly around all six degrees of freedom;

Fig. 6    a schematic representation of an embodiment of a method of estimating motion in combination with prospective and retrospective correction.; and

Fig. 7    a schematic representation of a second variant of a method of estimating motion in combination with prospective and retrospective correction.

## Detailed description of the invention

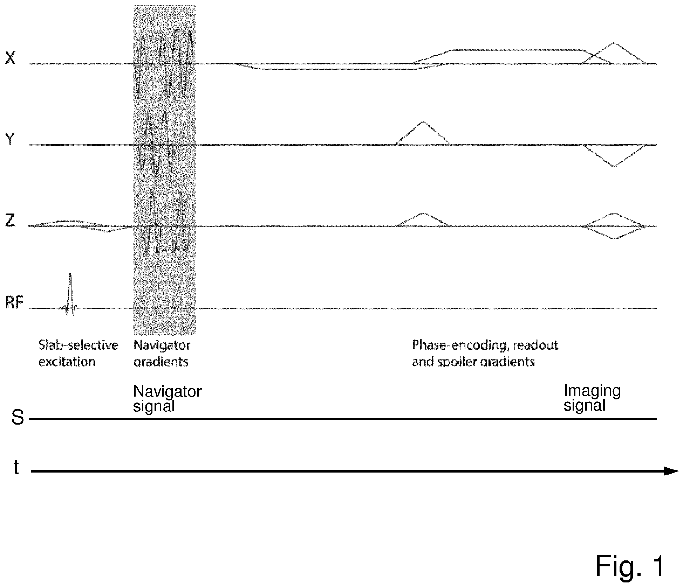

As generally known in the field of MR, the MR sequence comprises a train of sequence modules with a sequence repetition period TR between each pair of successive sequence modules. One such sequence module is shown schematically in Fig. 1, also showing a set of navigator gradient segments, which in the example shown are located after the excitation and before the image encoding gradient segments.

Example

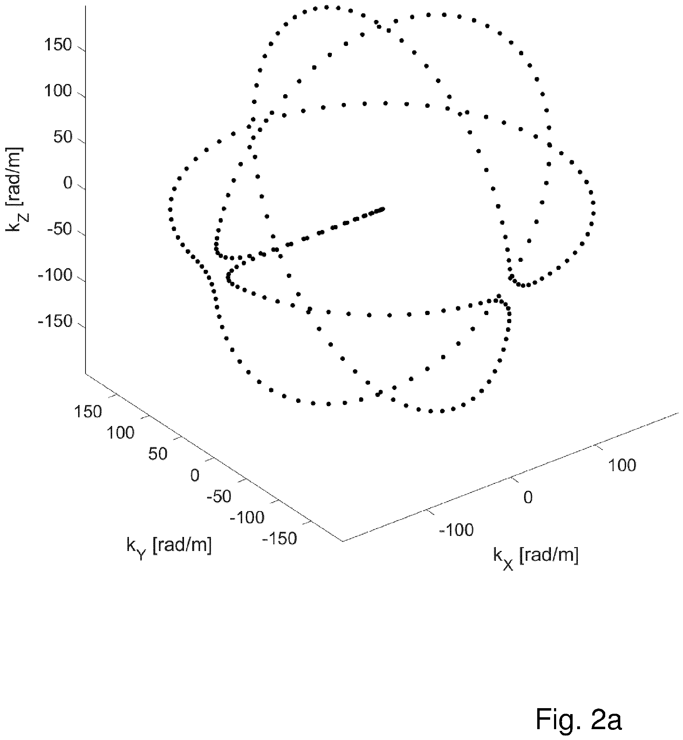

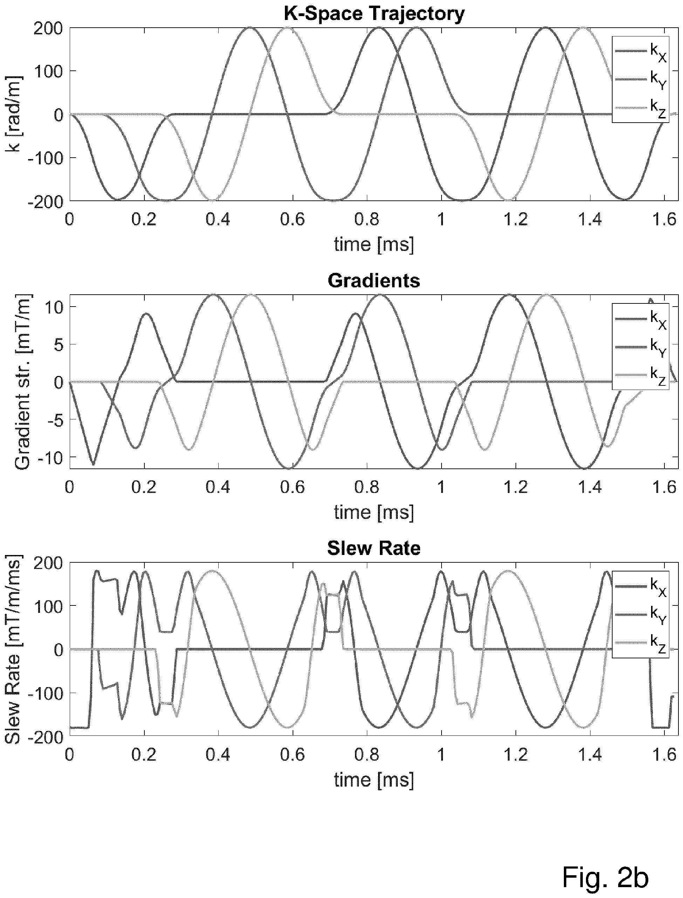

Experiments were performed at a 7T Philips Achieva scanner using a 32-channel head coil. We used a single-shot 3D orbital navigator [4], which is displayed in Fig. 2.

To examine the precision of the method, a motionless phantom (pineapple) was placed in the head coil. Navigator signals were acquired during a 3D T2*w-FFE imaging scan and motion parameters were estimated from the navigator signal.

We also performed two in-vivo experiments. For the first experiment, a volunteer was instructed to hold still during a 2.5-minute FFE scan sequence. During the second experiment, the volunteer was instructed to move their head around all six degrees of freedom. Motion parameters were estimated using our proposed algorithm.

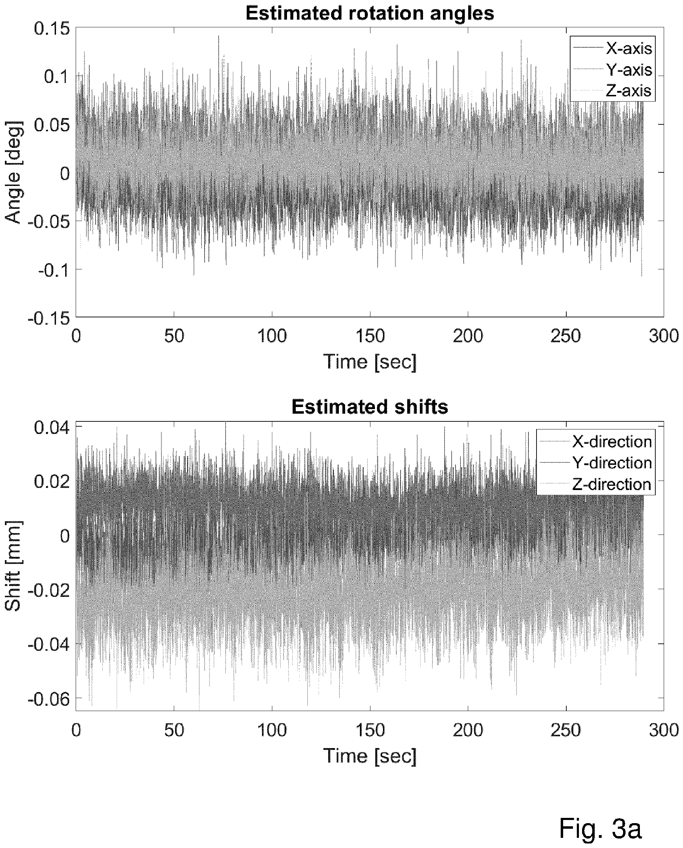

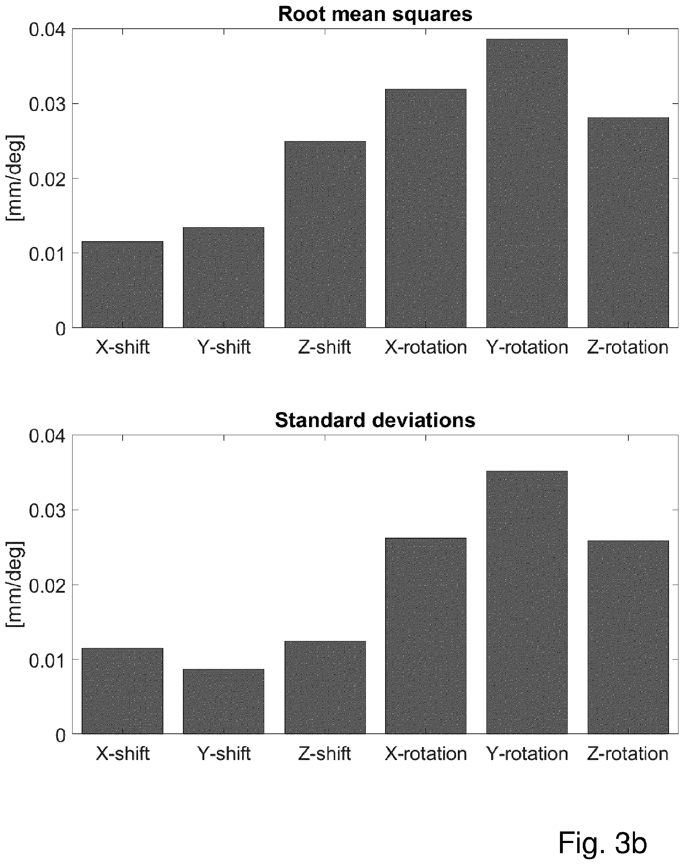

Fig. 3 shows the results from the experiment with the motionless phantom. The algorithm produced rotation angles in the range of $\pm 0.15$ degrees and shifts in the range of $\pm 60 \mu m$, with root-mean squares values of up to 0.04 degrees and $25 \mu m$.

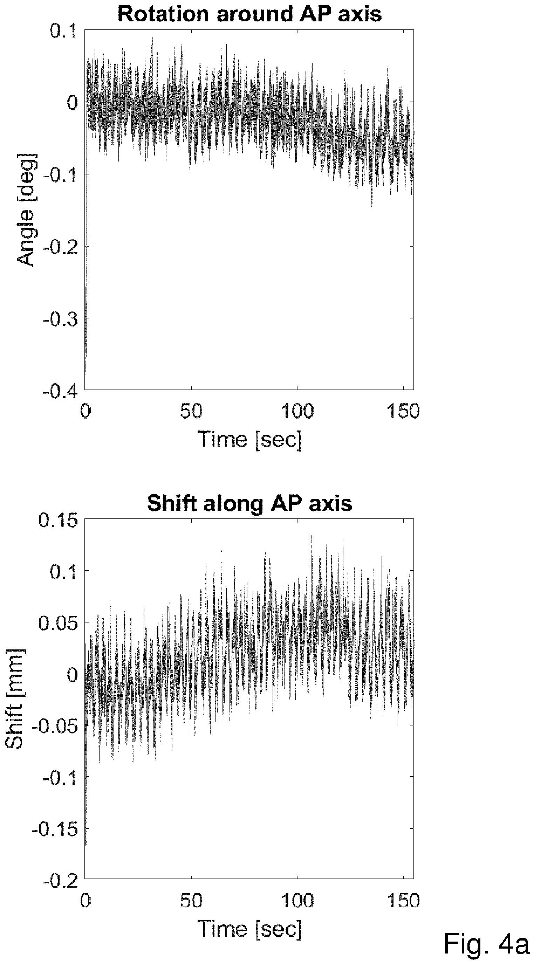

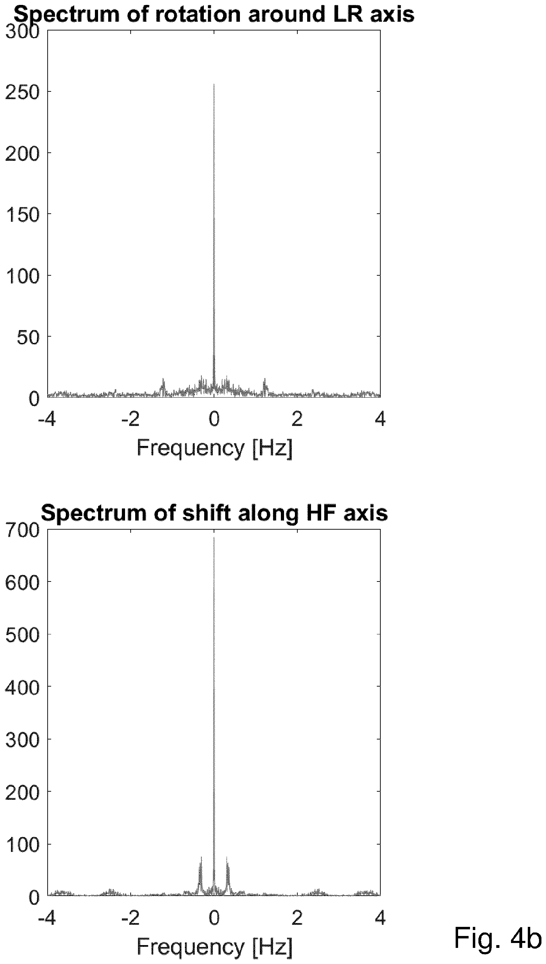

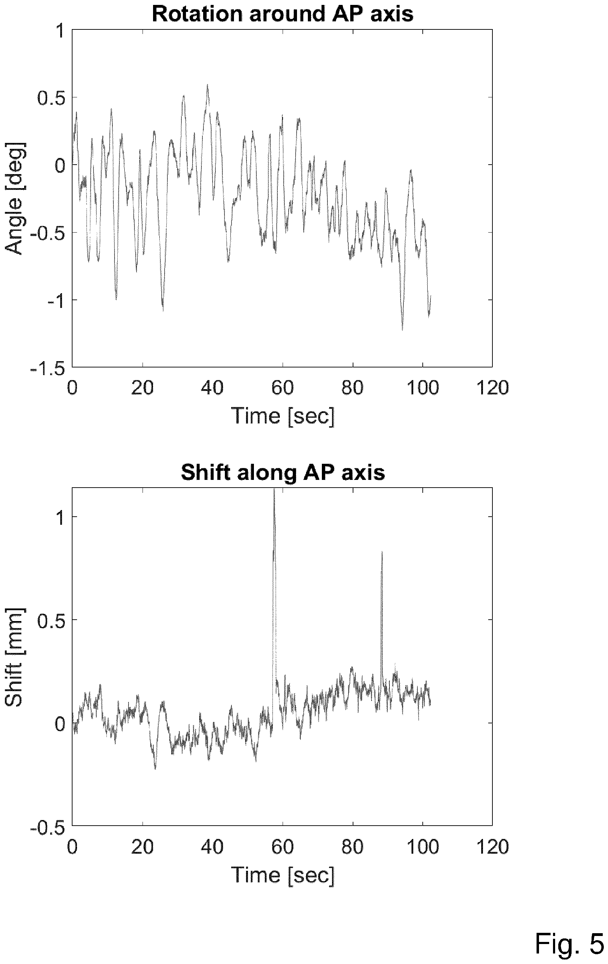

Fig. 4 and Fig. 5 show the estimated rotation angles and shifts from the two in-vivo experiments. During the experiment without intentional motion, the rotation was estimated to be within the range of $\pm 0.2$ degrees and $\pm 0.25mm$, except for the HF axis, where the estimated shift values seem to drift and oscillate around -0.2mm. The spectrum showed distinct peaks at 0.30 Hz and 1.22 Hz.

When the volunteer moved intentionally, rotation angles of up to $\pm 2$ degrees and shifts of $\pm 3.5mm$ were reported by our algorithm.

The phantom experiment demonstrates that our method exhibits high precision and accuracy. Since we know that no actual object motion has occurred, we can conclude that our method's estimates were correct up to the RMS error of 0.04 degrees and $25 \mu m$, and the standard deviation is of roughly the same size.

In case of the in-vivo experiment, no ground truth is available, unfortunately. However, the results indicate that our algorithm is sensitive to head motion. The peaks in the spectrum at 0.30 Hz and 1.22 Hz are likely due to respiration and heartbeat. Further investigation of the accuracy and precision for head motion estimation is to be conducted in the future.

To conclude, we have demonstrated that rigid-body motion can be accurately and precisely characterized using our motion estimation algorithm. The navigator readout is very fast and the algorithm has very low computational complexity, so the motion parameters can be calculated within milliseconds.

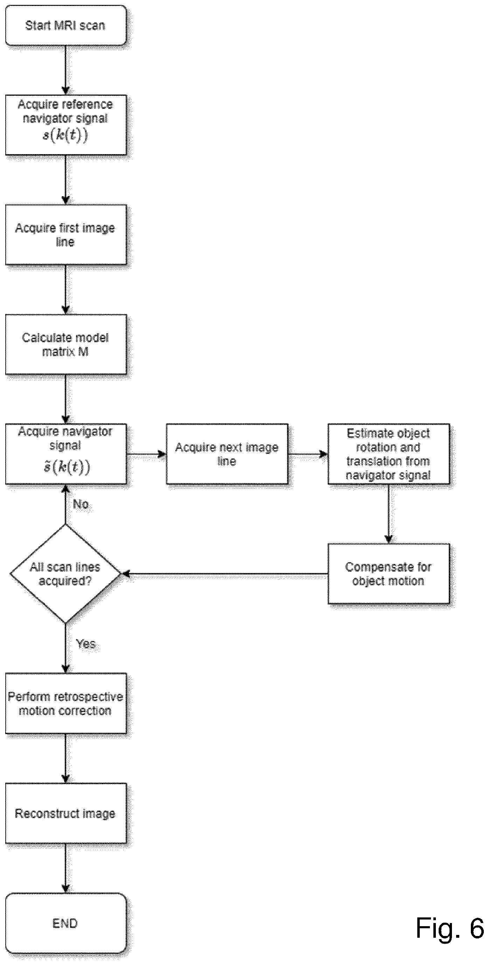

A first variant of a method of estimating motion in combination with prospective and retrospective correction is illustrated in Fig. 6.

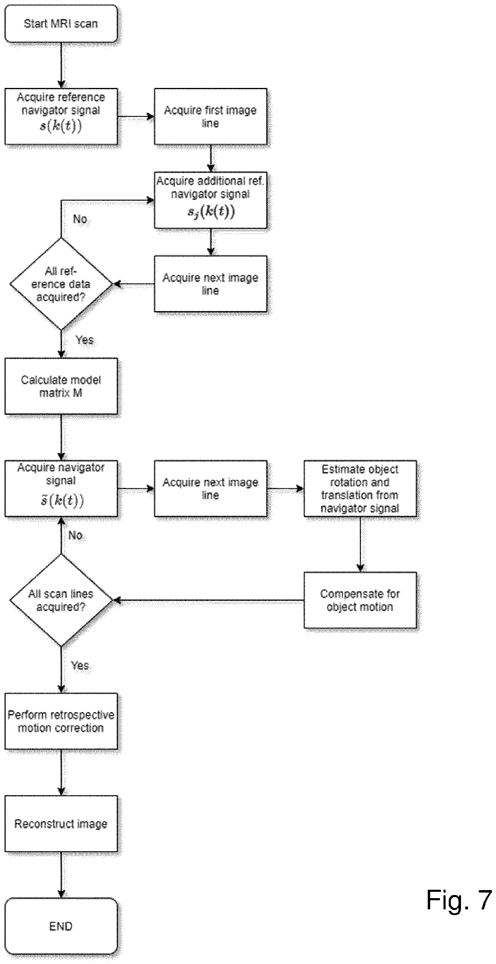

A second variant of a method of estimating motion in combination with prospective and retrospective correction is illustrated in Fig. 7.

*References*

[1] Zaitsev Maxim, Maclaren Julian & Herbst Michael. Motion artifacts in MRI: A complex problem with many partial solutions. Journal of Magnetic Resonance Imaging 42, 887-901 (2015).
[2] Godenschweger, F. et al. Motion correction in MRI of the brain. Phys. Med. Biol. 61, R32 (2016).
[3] Maclaren, J., Herbst, M., Speck, O. & Zaitsev, M. Prospective motion correction in brain imaging: A review. Magnetic Resonance in Medicine 69, 621-636 (2013).
[4] Ulrich, T., Patzig, F., Wilm, B. J. & Pruessmann, K. P. Towards Optimal Design of Orbital K-Space Navigators for 3D Rigid-Body Motion Estimation. ISMRM & SMRT Virtual Conference & Exhibition (2020).

**Claims**

1.  A method of estimating motion of an object during a magnetic resonance (MR) imaging scan of the object, wherein a main magnetic field is generated in the object by a main magnet and wherein superimposed magnetic fields and radiofrequency fields are generated according to an MR sequence for forming images,

    - the MR sequence comprising a train of sequence modules,
    - each sequence module comprising a radiofrequency (RF) excitation segment and an image encoding gradient segment,
    - said MR sequence further comprising a plurality of navigator gradient segments,
    in which method
    - object signal is acquired with an RF receive coil or coil array during a measurement segment of each sequence module,
    - navigator signal is acquired with said RF receive coil or coil array during each one of said navigator gradient segments,

    **characterized in that**:

    - said navigator signal is acquired along a trajectory $k(t)$ in k-space
    - said navigator signal in a given sequence module is expressed as a discrete time series comprising a predefined number N of complex-valued signal datapoints
    $s(k(t_i))$, wherein i = 1 to N,
    - a transformation matrix **M** which relates rotation angles and translational shifts to corresponding changes in navigator signal in a first order approximation is calculated from the navigator signal $s(k(t_i))$ acquired in a first sequence module, optionally including the navigator signal $s_j(k(t_i))$ acquired in at least one further sequence module,
    - the navigator signal $\tilde{s}(k(t_i))$ acquired in a subsequent sequence module is used to estimate object motion in terms of a translational displacement $\Delta x$ and a rotational displacement $\theta$ of the object between said first sequence module and said subsequent sequence module by solving the following linear least-squares estimation problem:

    $$\min_{\Delta x_1, \Delta x_2, \Delta x_3, \theta_1, \theta_2, \theta_3} \left\| (\tilde{s} - s) - M \begin{pmatrix} \Delta x_1 \\ \Delta x_2 \\ \Delta x_3 \\ \theta_1 \\ \theta_2 \\ \theta_3 \end{pmatrix} \right\|_2^2$$

2.  The motion estimating method of claim 1, wherein said linear least squares estimation problem is solved by multiplication of the navigator signal difference with the Moore-Penrose pseudoinverse matrix $M^+$ of said transformation matrix M.

3.  The motion estimating method of claim 1 or 2, wherein one navigator gradient segment is executed in each one of said sequence modules.

4.  The motion estimating method of claim 3, wherein the navigator gradient segment of a respective sequence module is executed between the RF excitation segment and the image encoding segment of said respective sequence module.

5.  The motion estimating method of claim 3, wherein each navigator gradient segment of a respective sequence module is executed after the image encoding segment of said respective sequence module but before the RF excitation segment of a sequence module following said respective sequence module.

6.  A method of estimating magnetic field offsets in a region surrounding an object during a magnetic resonance (MR) imaging scan of the object, wherein a main magnetic field is generated in the object by a main magnet and wherein superimposed magnetic fields and radiofrequency fields are generated according to an MR sequence for forming images,

- the MR sequence comprising a train of sequence modules,
- each sequence module comprising a radiofrequency (RF) excitation segment and an image encoding gradient segment,
- said MR sequence further comprising a plurality of navigator gradient segments, in which method
- object signal is acquired with an RF receive coil or coil array during a measurement segment of each sequence module,
- navigator signal is acquired with said RF receive coil or coil array during each one of said navigator gradient segments,

**characterized in that**:

- said navigator signal is acquired along a trajectory *k(t)* in k-space
- said navigator signal in a given sequence module is expressed as a discrete time series comprising a predefined number N of complex-valued signal datapoints
$s(k(t_i))$, wherein i = 1 to N,
- a transformation matrix Q which relates changes of the magnetic field to corresponding changes in navigator signal in a first order approximation is calculated from the navigator signal $s(k(t_i))$ acquired in a first sequence module, optionally including the navigator signal $s_j(k(t_i))$ acquired in at least one further sequence module,
- the navigator signal $\tilde{s}(k(t_i))$ acquired in a subsequent sequence module is used to estimate magnetic field offsets in terms of a zeroth-order field variation $\Delta B_0$ and a first-order field variation $\begin{pmatrix} G_1 \\ G_2 \\ G_3 \end{pmatrix}$ between said first sequence module and said subsequent sequence module by solving the following linear least-squares estimation problem:

$$\min_{\Delta B_0, G_1, G_2, G_3} \left\| (\tilde{s} - s) - Q \begin{pmatrix} \Delta B_0 \\ G_1 \\ G_2 \\ G_3 \end{pmatrix} \right\|_2^2$$

7. A method of estimating motion of an object and magnetic field offsets in a region surrounding the object during a magnetic resonance (MR) imaging scan of the object, wherein superimposed magnetic fields and radiofrequency fields are generated according to an MR sequence for forming images,

- the MR sequence comprising a train of sequence modules,
- each sequence module comprising a radiofrequency (RF) excitation segment and an image encoding gradient segment,
- said MR sequence further comprising a plurality of navigator gradient segments, in which method
- object signal is acquired with an RF receive coil or coil array during a measurement segment of each sequence module,
- navigator signal is acquired with said RF receive coil or coil array during each one of said navigator gradient segments,

**characterized in that**:

- said navigator signal is acquired along a trajectory *k(t)* in k-space
- said navigator signal in a given sequence module is expressed as a discrete time series comprising a predefined number N of complex-valued signal datapoints
$s(k(t_i))$, wherein i = 1 to N,
- a transformation matrix R which relates rotation angles, translational shifts and changes of the magnetic field to corresponding changes in navigator signal in a first order approximation is calculated from the navigator signal $s(k(t_i))$ acquired in a first sequence module, optionally including the navigator signal $s_j(k(t_i))$ acquired in at least one further sequence module,

- the navigator signal $\tilde{\boldsymbol{s}}(\boldsymbol{k}(\boldsymbol{t_i}))$ acquired in a subsequent sequence module is used to estimate object motion in terms of a translational displacement $\Delta\boldsymbol{x}$ and a rotational displacement $\theta$ of the object and magnetic field offsets in terms of a scalar field variation $\Delta B_0$ and a vectorial field variation $\begin{pmatrix} G_1 \\ G_2 \\ G_3 \end{pmatrix}$ be-tween said first sequence module and said subsequent sequence module by solving the following linear least-squares estimation problem:

$$\min_{\Delta x,\theta,\Delta B_0,G_1,G_2,G_3} \left\| (\tilde{\boldsymbol{s}} - \boldsymbol{s}) - R \begin{pmatrix} \Delta x_1 \\ \Delta x_2 \\ \Delta x_3 \\ \theta_1 \\ \theta_2 \\ \theta_3 \\ \Delta B_0 \\ G_1 \\ G_2 \\ G_3 \end{pmatrix} \right\|_2^2$$

8. A method of prospectively correcting for motion of an object and/or for magnetic field offsets in a region surrounding the object during a magnetic resonance (MR) imaging scan of the object, wherein a method according to one of claims 1 to 7 is carried out yielding an estimate of the object's motion and/or magnetic field offsets, which estimate is used to correct a subsequent execution of the sequence module, including the navigator.

9. A method of retrospectively correcting for motion of an object and/or for magnetic field offsets in a region surrounding the object during a magnetic resonance (MR) imaging scan of the object, wherein a method according to one of claims 1 to 7, is carried out yielding an estimate of the object's motion and/or magnetic field offsets, which estimate is used to correct an MR image reconstructed from said MR image forming sequence.

10. A method of correcting for motion of an object and/or for magnetic field offsets in a region surrounding the object during a magnetic resonance (MR) imaging scan of the object, comprising the steps of claims 8 and 9.

Fig. 1

Fig. 2a

Fig. 2b

Fig. 3a

**Fig. 3b**

Fig. 4a

## Spectrum of rotation around LR axis

## Spectrum of shift along HF axis

Fig. 4b

Fig. 5

Fig. 6

Fig. 7

Europäisches
Patentamt

European
Patent Office

Office européen
des brevets

# EUROPEAN SEARCH REPORT

Application Number

EP 22 16 5204

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | THOMAS ULRICH AND KLAAS PAUL PRUESSMAN: "Detection of Head Motion using Navigators and a Linear Perturbation Model", PROCEEDINGS OF THE 2021 ISMRM & SMRT ANNUAL MEETING & EXHIBITION, 15-20 MAY 2021, ISMRM, 2030 ADDISON STREET, 7TH FLOOR, BERKELEY, CA 94704 USA, no. 1389, 30 April 2021 (2021-04-30), XP040723408, * the whole document * | 1-5,8-10 | INV. G01R33/565 |
|  | ----- |  |  |

TECHNICAL FIELDS
SEARCHED     (IPC)

G01R

The present search report has been drawn up for all claims

| Place of search | Date of completion of the search | Examiner |
|---|---|---|
| Munich | 7 September 2022 | Vanhaecke, Nicolas |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons
 
& : member of the same patent family, corresponding
     document

EPO FORM 1503 03.82 (P04C01)

Europäisches
Patentamt

European
Patent Office

Office européen
des brevets

Application Number

EP 22 16 5204

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

[X] None of the further search fees have been paid within the fixed time limit. The present European search report has been drawn up for those parts of the European patent application which relate to the invention first mentioned in the claims, namely claims:

1-5(completely); 8-10(partially)

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**

**SHEET B**

Application Number

**EP 22 16 5204**

The Search Division considers that the present European patent application does not comply with the requirements of unity of invention and relates to several inventions or groups of inventions, namely:

```
1. claims: 1-5(completely); 8-10(partially)

        a method of estimating motion of an object in the frame of
        magnetic resonance imaging
                          ---


2. claims: 6(completely); 8-10(partially)

        a method of estimating magnetic field offsets in the frame
        of magnetic resonance imaging
                          ---


3. claims: 7(completely); 8-10(partially)

        a method of jointly estimating motion of an object and
        magnetic field offsets in the frame of magnetic resonance
        imaging
                          ---
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6771068 B2

- US 7358732 B2

### Non-patent literature cited in the description

- **ZAITSEV MAXIM ; MACLAREN JULIAN ; HERBST MICHAEL.** Motion artifacts in MRI: A complex problem with many partial solutions. *Journal of Magnetic Resonance Imaging,* 2015, vol. 42, 887-901
- **GODENSCHWEGER, F. et al.** Motion correction in MRI of the brain. *Phys. Med. Biol.,* 2016, vol. 61, R32

- **MACLAREN, J. ; HERBST, M. ; SPECK, O. ; ZAITSEV, M.** Prospective motion correction in brain imaging: A review. *Magnetic Resonance in Medicine,* 2013, vol. 69, 621-636
- **ULRICH, T. ; PATZIG, F. ; WILM, B. J. ; PRUESSMANN, K. P.** Towards Optimal Design of Orbital K-Space Navigators for 3D Rigid-Body Motion Estimation. *ISMRM & SMRT Virtual Conference & Exhibition,* 2020